(19) Europäisches Patentamt
European Patent Office
Office européen des brevets

(11) **EP 4 165 422 B1**

(12) **EUROPÄISCHE PATENTSCHRIFT**

(45) Veröffentlichungstag und Bekanntmachung des Hinweises auf die Patenterteilung:
**29.10.2025 Patentblatt 2025/44**

(21) Anmeldenummer: **21734078.5**

(22) Anmeldetag: **15.06.2021**

(51) Internationale Patentklassifikation (IPC):
**G01R 31/392** (2019.01)     **G01R 31/396** (2019.01)
**H02J 7/00** (2006.01)

(52) Gemeinsame Patentklassifikation (CPC):
**G01R 31/396; B60L 58/16; B60L 58/21;
G01R 31/392; H02J 7/005;** B60L 2240/547;
G01R 31/3835; Y02T 10/70

(86) Internationale Anmeldenummer:
**PCT/EP2021/066043**

(87) Internationale Veröffentlichungsnummer:
**WO 2021/254995 (23.12.2021 Gazette 2021/51)**

(54) **VERFAHREN ZUR BESTIMMUNG EINES ZUSTANDS EINER ZELLE EINER BATTERIE**

METHOD FOR DETERMINING A STATE OF A CELL OF A BATTERY

PROCÉDÉ DE DÉTERMINATION DE L'ÉTAT D'UN ÉLÉMENT D'UNE BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.06.2020 DE 102020115887**

(43) Veröffentlichungstag der Anmeldung:
**19.04.2023 Patentblatt 2023/16**

(73) Patentinhaber:
• **VOLKSWAGEN AKTIENGESELLSCHAFT 38440 Wolfsburg (DE)**
• **Stodia GmbH 38518 Gifhorn (DE)**

(72) Erfinder:
• **SEIDEL, André 38518 Gifhorn (DE)**
• **KÖHLER, Jan-Michael 38118 Braunschweig (DE)**
• **RUDOLPH, Stephan 38459 Bahrdorf (DE)**
• **BAIANOV, Ilmir 38170 Schöppenstedt (DE)**

(74) Vertreter: **karo IP Patentanwälte PartG mbB Steinstraße 16-18 40212 Düsseldorf (DE)**

(56) Entgegenhaltungen:
DE-T2- 69 123 822      US-A1- 2014 278 169
US-A1- 2016 266 210

**Beschreibung**

Die Erfindung betrifft ein Verfahren zur Bestimmung eines Zustands einer Zelle einer Batterie, insbesondere einer Hochvoltbatterie. Insbesondere ist das Verfahren auf die Bestimmung eines Zustands einer Zelle unter Berücksichtigung der Zustände anderer Zellen derselben Batterie gerichtet.

Derartige Hochvoltbatterien werden insbesondere in Kraftfahrzeugen zur Speicherung von elektrischer Energie für den Antrieb von Traktionsantrieben eingesetzt. Dabei setzt sich eine Batterie regelmäßig aus einer Mehrzahl von Zellen zusammen, wobei jede Zelle eine Klemmenspannung von 1,5 bis 4 Volt aufweist. Die Zellen werden zumindest teilweise in Reihe geschaltet, so dass eine Traktionsspannung von 60 bis 1.500 Volt Gleichspannung bereitgestellt wird.

Aufgrund aktueller und kommender Gesetzgebungen ist es erforderlich, den Zustand der Batterie bzw. der Zellen im Betrieb eines Kraftfahrzeuges zu erfassen. Insbesondere kann durch die Bestimmung des Zustands der Zellen eine Ausfall-Früherkennung und eine Service-Früherkennung erfolgen, so dass ein Ausfall einer Zelle bzw. der Batterie im Betrieb vermieden wird und ein rechtzeitiger Austausch der Zelle bzw. der Batterie vorgenommen werden kann.

Die bekannten Verfahren zur Bestimmung eines Zustands einer Zelle oder einer Batterie liefern meistens nur Momentaufnahmen, wobei die Entwicklung des Zustands (z. B. SOH - state of health) der Zelle bzw. der Batterie nicht erfasst wird.

Aus der DE 10 2009 000 337 A1 ist ein Verfahren zur Bestimmung eines Alterungszustands einer Batteriezelle bekannt. Dabei wird ein Impedanzspektrum der Batteriezelle aufgenommen.

Aus der DE 10 2011 117 249 A1 ist ein Verfahren zum Überwachen einer Lithium-Ionen-Batteriezelle bekannt. Dabei wird eine Ladekapazität nach der entsprechenden Batteriezellenspannung differenziert.

Aus der DE 10 2014 214 314 A1 ist ein Verfahren zum Betreiben einer Sekundärbatterie bekannt. Dabei werden Zustandsparameter einzelner Zellen erfasst und daraus eine Betriebsstrategie abgeleitet.

Die US 2014/278169 A1 ist auf ein Verfahren zur Berechnung eines SOC (state of health) einer Batteriezelle gerichtet.

Die US 2016/266210 A1 ist auf ein System gerichtet, durch das die Leistung einer Batterie überwacht werden kann.

Aufgabe der vorliegenden Erfindung ist es, die mit Bezug auf den Stand der Technik angeführten Probleme zumindest teilweise zu lösen. Insbesondere soll ein Verfahren zur Bestimmung eines Zustands einer Zelle einer Batterie erfasst werden. Insbesondere soll durch das Verfahren auch eine Aussage zur Entwicklung des Zustands über Lebensdauer ermöglichen.

Zur Lösung dieser Aufgaben trägt ein Verfahren mit den Merkmalen gemäß Patentanspruch 1 sowie ein Steuergerät gemäß Patentanspruch 10 bei. Vorteilhafte Weiterbildungen sind Gegenstand der abhängigen Patentansprüche. Die in den Patentansprüchen einzeln aufgeführten Merkmale sind in technologisch sinnvoller Weise miteinander kombinierbar und können durch erläuternde Sachverhalte aus der Beschreibung und/oder Details aus den Figuren ergänzt werden, wobei weitere Ausführungsvarianten der Erfindung aufgezeigt werden.

Es wird ein Verfahren zur Bestimmung eines jeweiligen Zustands einer Mehrzahl von Zellen einer Batterie vorgeschlagen. Insbesondere soll durch das Verfahren der Zustand mindestens einer Zelle der Batterie bestimmt werden können, bevorzugt jeder Zelle der Batterie.

Das Verfahren umfasst zumindest die folgenden Schritte:

    a) Durchführen eines Beladevorgangs oder eines Entladevorgangs der Zellen;
    b) Ermittlung einer Entladespannung jeder der Zellen und einer Beladespannung jeder der Zellen;
    c) Bestimmen mindestens eines Zustandsparameters für jede Zelle, wobei der Zustandsparameter aus der Entladespannung und der Beladespannung abgeleitet wird, wobei für den Zustandsparameter eine Entladespannung und eine Beladespannung zumindest einer anderen Zelle berücksichtigt wird.

Die obige (nicht abschließende) Einteilung der Verfahrensschritte in a) bis c) soll vorrangig nur zur Unterscheidung dienen und keine Reihenfolge und/oder Abhängigkeit erzwingen. Auch die Häufigkeit der Verfahrensschritte z. B. während der Einrichtung und/oder des Betriebes des Systems kann variieren. Ebenso ist möglich, dass Verfahrensschritte einander zumindest teilweise zeitlich überlagern. Ganz besonders bevorzugt finden die Verfahrensschritte b) und c) während oder unmittelbar nach Schritt a) statt. Insbesondere werden die Schritte a) bis c) in der angeführten Reihenfolge durchgeführt.

Der Beladevorgang und Entladevorgang bezeichnet jeweils einen Ladevorgang, bei dem der Zelle ein elektrischer Strom ausschließlich zugeführt (Beladevorgang) oder aus der Zelle ein elektrischer Strom ausschließlich abgeführt (Entladevorgang) wird. Dabei kann insbesondere jeder Ladevorgang, unabhängig von der Menge des zu- oder abgeführten elektrischen Stroms, mit dem Verfahren ausgewertet werden.

Im Rahmen des Schrittes b) wird für jede der betrachteten Zellen eine Entladespannung und eine Beladespannung ermittelt bzw. gemessen. Die Entladespannung bezeichnet die Spannung der Zelle, die nach dem Entladevorgang vorliegt. Die Beladespannung bezeichnet die Spannung der Zelle, die nach dem Beladevorgang vorliegt. Die Spannungen der Mehrzahl von Zellen werden insbesondere jeweils zu einem gleichen Zeitpunkt ermittelt, also alle Entladespannungen zu einem gemeinsamen Zeitpunkt und alle Beladespannungen zu einem anderen gemeinsamen Zeitpunkt.

Die Entladespannung ist insbesondere die geringste Spannung eines Ladevorgangs. Die Beladespannung ist insbesondere die höchste Spannung eines Ladevorgangs.

Insbesondere kann ein Ladevorgang zur mehrmaligen Durchführung des Verfahrens genutzt werden. Z. B. kann zu bestimmten Zeitpunkten während des weiter fortschreitenden Ladevorgangs die jeweilige Spannung der Zellen ermittelt werden und das Verfahren unter Berücksichtigung dieser Spannungen durchgeführt werden.

Im Rahmen des Schrittes c) wird mindestens ein Zustandsparameter für jede betrachtete Zelle bestimmt. Dieser wird aus der Entladespannung und der Beladespannung dieser Zelle abgeleitet. Dabei werden aber insbesondere auch die entsprechenden Spannungen zumindest einer anderen Zelle, insbesondere aber aller anderen betrachteten Zellen berücksichtigt.

Insbesondere wird der Zustandsparameter durch eine Normierung ermittelt. Die Normierung ermöglicht die Vergleichbarkeit der Zustände der unterschiedlichen Zellen miteinander.

Insbesondere wird der mindestens eine Zustandsparameter für eine Mehrzahl zumindest von Beladevorgängen oder Ladevorgängen ermittelt, wobei eine Entwicklung der so ermittelten Zustandsparameter berücksichtigt wird.

Da das Verfahren zu jedem Zeitpunkt und für jede Art von Ladevorgang bzw. unabhängig von der Menge des entnommenen oder zugeführten elektrischen Stroms durchgeführt werden kann, ist eine Plausibilisierung vorheriger Ergebnisse leicht realisierbar. Dabei können also vorher ermittelte Zustandsparameter durch häufige Wiederholung des Verfahrens überprüft bzw. verifiziert werden. Weiter lässt sich so eine Entwicklung der Zustandsparameter und damit der Zustand der Zelle in hoher zeitlicher Auflösung verfolgen.

Gemäß der Erfindung ist der eine Zustandsparameter zumindest ein Kapazitätsparameter oder ein Gleichgewichtsparameter. Der Kapazitätsparameter beschreibt ein Verhältnis der Entladespannung und der Beladespannung einer Zelle unter Berücksichtigung des Verhältnisses anderer Zellen. Insbesondere beschreibt der Kapazitätsparameter also die Differenz zwischen der Entladespannung und der Beladespannung eines Ladevorgangs einer Zelle. Eine große Differenz entspricht einer geringen Kapazität der Zelle, da eine geringe Menge an elektrischem Strom einen großen Unterschied der Spannung der Zelle verursacht. Umgekehrt entspricht eine geringe Differenz einer hohen Kapazität der Zelle.

Der Gleichgewichtsparameter beschreibt ein Niveau der Entladespannung und ein Niveau der Beladespannung einer Zelle im Vergleich zu den jeweiligen Niveaus der Spannungen anderer Zellen. Insbesondere beschreibt der Gleichgewichtsparameter den Unterschied zwischen einem ersten Niveau, also dem Wert, der Beladespannung einer Zelle im Vergleich zu den jeweiligen ersten Niveaus der Beladespannung der anderen Zellen und einem zweiten Niveau der Entladespannung der Zelle im Vergleich zu den jeweiligen zweiten Niveaus der Entladespannung der anderen Zellen.

Ein negatives Gleichgewicht bedeutet z. B., dass eine im Vergleich mit den anderen Zellen am tiefsten entladene Zelle, d. h. es liegt eine geringste Entladespannung aller Zellen vor, in einem Beladevorgang am geringsten beladen wird, d. h. es liegt eine geringste Beladespannung aller Zellen vor.

Ein positives Gleichgewicht bedeutet z. B., dass eine im Vergleich mit den anderen Zellen am wenigsten entladene Zelle, d. h. es liegt eine höchste Entladespannung aller Zellen vor, in einem Beladevorgang am stärksten beladen wird, d. h. es liegt eine höchste Beladespannung aller Zellen vor.

Ein ausgeglichenes Gleichgewicht bedeutet z. B., dass eine im Vergleich mit den anderen Zellen z. B. drittgeringste entladene Zelle, d. h. es liegt eine drittgeringste Entladespannung aller Zellen vor, in einem Beladevorgang am drittstärksten beladen wird, d. h. es liegt eine dritthöchste Beladespannung aller Zellen vor.

Insbesondere wird zum Bestimmen der Zustandsparameter die ermittelte Entladespannung und Beladespannung jeder Zelle normiert. Für die normierte Beladespannung $x_i$ einer Zelle i gilt:

$$x_i = \frac{U_{xi} - U_{xmin}}{U_{xmax} - U_{xmin}}$$ ; wobei für die normierte Entladespannung $y_i$ einer Zelle i gilt:

$$y_i = \frac{U_{yi} - U_{ymin}}{U_{ymax} - U_{ymin}} - 1$$ . Dabei ist

$U_{xi}$: die Beladespannung der betrachteten Zelle i,
$U_{xmin}$: die maximale Beladespannung aller betrachteten Zellen i = 1 bis n,
$U_{xmin}$: die minimale Beladespannung aller betrachteten Zellen i = 1 bis n,
$U_{yi}$: die Entladespannung der betrachteten Zelle i,
$U_{ymin}$: die maximale Entladespannung aller betrachteten Zellen i = 1 bis n,
$U_{xmin}$: die minimale Entladespannung aller betrachteten Zellen i = 1 bis n.

Die Anzahl der Zellen beträgt hier also n, wobei i bzw. n jeweils eine natürliche Zahl ist, also n = 2, 3, 4,...

Die Normierung für die Beladespannung erfolgt also durch eine Differenz zwischen der maximalen Beladespannung aller Zellen und der minimalen Beladespannung aller Zellen in diesem Ladevorgang.

Die Normierung für die Entladespannung erfolgt also durch eine Differenz zwischen der maximalen Entladespannung aller Zellen und der minimalen Entladespannung aller Zellen in diesem Ladevorgang.

Die Normierung ermöglicht den Vergleich der einen Zelle mit den anderen Zellen der Batterie.

Insbesondere ist der mindestens eine Zustand-

sparameter ein Kapazitätsparameter $C_i$ einer Zelle i, wobei gilt: $C_i = 2 - (x_i - y_i)$.

Insbesondere ist der mindestens eine Zustandsparameter ein Gleichgewichtsparameter $B_i$ einer Zelle i ist, wobei gilt: $B_i = 1 - |x_i + y_i|$.

Insbesondere wird zur Bestimmung des Zustands einer Zelle ein Kehrwert des Zustandsparameters betrachtet. Der Kehrwert von $C_i$ ist insbesondere $1/C_i$.

Der Kehrwert von $B_i$ ist insbesondere $1/B_i$.

Insbesondere ist für jeden Zustandsparameter eine Eingriffsgrenze definiert, bei deren Überschreitung auf einen Reparatur-Status der betreffenden Zelle entschieden wird.

Insbesondere wird die Eingriffsgrenze in Abhängigkeit von den für die Mehrzahl der Zellen bestimmten Zustandsparameter bestimmt.

Insbesondere wird für den jeweiligen Zustandsparameter ein arithmetischer Mittelwert dieser Zustandsparameter der betrachteten Zellen gebildet, wobei die Eingriffsgrenze z. B. bei mindestens 130 %, bevorzugt mindestens 150 % oder sogar 200 % dieses Mittelwertes liegt.

Insbesondere wird die Eingriffsgrenze für den jeweils letzten Beladevorgang oder Entladevorgang neu bestimmt. Insbesondere kann also z. B. der arithmetische Mittelwert bei jedem Ladevorgang neu ermittelt werden. Damit kann eine insbesondere kontinuierliche Degradation der Zellen über Lebenszeit berücksichtigt werden.

Das Verfahren kann insbesondere in einem Steuergerät implementiert sein, wobei das Steuergerät zumindest zur Diagnose, ggf. auch zum Betrieb, der Batterie vorgesehen ist.

Die Batterie kann in einem Kraftfahrzeug zur Speicherung von Energie eingesetzt werden, wobei über die Batterie zumindest ein Traktionsantrieb des Kraftfahrzeuges mit elektrischer Energie versorgt wird.

Es wird insbesondere ein Kraftfahrzeug mit einem Traktionsantrieb und der beschriebenen Batterieanordnung vorgeschlagen.

Gemäß der Erfindung wird weiter ein Steuergerät vorgeschlagen, das zur Durchführung des beschriebenen Verfahrens konfiguriert ist.

Weiter kann das Verfahren auch von einem Computer bzw. mit einem Prozessor einer Steuereinheit bzw. eines Datenverarbeitungssystem ausgeführt werden.

Es wird demnach auch ein System zur Datenverarbeitung vorgeschlagen, das einen Prozessor umfasst, der so angepasst/konfiguriert ist, dass er das Verfahren bzw. einen Teil der Schritte des vorgeschlagenen Verfahrens durchführt. Insbesondere umfasst das System zur Datenverarbeitung zur Zustandsbestimmung einer Mehrzahl von Zellen einer Batterie mit mindestens einen Spannungsdetektor zur Ermittlung bzw. Messung der Spannung (z. B. Beladespannung und Entladespannung) und Mittel, die geeignet sind, die Schritte des beschriebenen Verfahrens auszuführen

Es kann ein computerlesbares Speichermedium vorgesehen sein, das Befehle umfasst, die bei der Ausführung durch einen Computer/Prozessor diesen veranlassen, das Verfahren bzw. mindestens einen Teil der Schritte des vorgeschlagenen Verfahrens auszuführen.

Die Ausführungen zu dem Verfahren sind insbesondere auf die Batterieanordnung, das Kraftfahrzeug und/oder das computerimplementierte Verfahren (also den Computer bzw. den Prozessor, das System zur Datenverarbeitung, das computerlesbare Speichermedium) übertragbar und umgekehrt.

Die Verwendung unbestimmter Artikel ("ein", "eine", "einer" und "eines"), insbesondere in den Patentansprüchen und der diese wiedergebenden Beschreibung, ist als solche und nicht als Zahlwort zu verstehen. Entsprechend damit eingeführte Begriffe bzw. Komponenten sind somit so zu verstehen, dass diese mindestens einmal vorhanden sind und insbesondere aber auch mehrfach vorhanden sein können.

Vorsorglich sei angemerkt, dass die hier verwendeten Zahlwörter ("erste", "zweite", ...) vorrangig (nur) zur Unterscheidung von mehreren gleichartigen Gegenständen, Größen oder Prozessen dienen, also insbesondere keine Abhängigkeit und/oder Reihenfolge dieser Gegenstände, Größen oder Prozesse zueinander zwingend vorgeben. Sollte eine Abhängigkeit und/oder Reihenfolge erforderlich sein, ist dies hier explizit angegeben oder es ergibt sich offensichtlich für den Fachmann beim Studium der konkret beschriebenen Ausgestaltung. Soweit ein Bauteil mehrfach vorkommen kann ("mindestens ein"), kann die Beschreibung zu einem dieser Bauteile für alle oder ein Teil der Mehrzahl dieser Bauteile gleichermaßen gelten, dies ist aber nicht zwingend.

Die Erfindung sowie das technische Umfeld werden nachfolgend anhand der beiliegenden Figuren näher erläutert. Es ist darauf hinzuweisen, dass die Erfindung durch die angeführten Ausführungsbeispiele nicht beschränkt werden soll. Insbesondere ist es, soweit nicht explizit anders dargestellt, auch möglich, Teilaspekte der in den Figuren erläuterten Sachverhalte zu extrahieren und mit anderen Bestandteilen und Erkenntnissen aus der vorliegenden Beschreibung zu kombinieren. Insbesondere ist darauf hinzuweisen, dass die Figuren und insbesondere die dargestellten Größenverhältnisse nur schematisch sind. Es zeigen:

Fig. 1:  zwei Diagramme, in denen ein Beladevorgang einer Batterie dargestellt ist;

Fig. 2:  drei Diagramme, in denen ein zwischenzeitlicher Entladevorgang dargestellt ist;

Fig. 3:  ein Diagramm, in dem eine Zelle mit geringer Kapazität dargestellt ist;

Fig. 4: ein Diagramm, in dem eine Zelle mit großer Kapazität dargestellt ist;

Fig. 5: ein Diagramm, in dem eine Zelle mit negativem Gleichgewicht dargestellt ist;

Fig. 6: ein Diagramm, in dem eine Zelle mit positivem Gleichgewicht dargestellt ist;

Fig. 7: ein Diagramm, in dem eine Zelle mit ausgeglichenem Gleichgewicht dargestellt ist;

Fig. 8: zwei Diagramme, in denen ein Beladevorgang einer Mehrzahl von Zellen und deren normierte Spannungen dargestellt sind;

Fig. 9: ein Diagramm, in dem die Kapazitätsparameter der Mehrzahl der Zellen nach Fig. 8 dargestellt sind;

Fig. 10: ein Diagramm, in dem die Gleichgewichtsparameter der Mehrzahl der Zellen nach Fig. 8 dargestellt sind;

Fig. 11: ein Diagramm, in dem die Kehrwerte der Kapazitätsparameter nach Fig. 9 dargestellt sind;

Fig. 12: ein Diagramm, in dem die Kehrwerte der Gleichgewichtsparameter nach Fig. 10 dargestellt sind;

Fig. 13: drei Diagramme, in denen die normierten Spannungen, die Kehrwerte der Kapazitätsparameter und die Kehrwerte der Gleichgewichtsparameter aller Zellen für einen Ladevorgang dargestellt sind; und

Fig. 14: drei Diagramme, in denen die Kehrwerte der Kapazitätsparameter aller Zellen für drei verschiedene Ladevorgänge dargestellt sind.

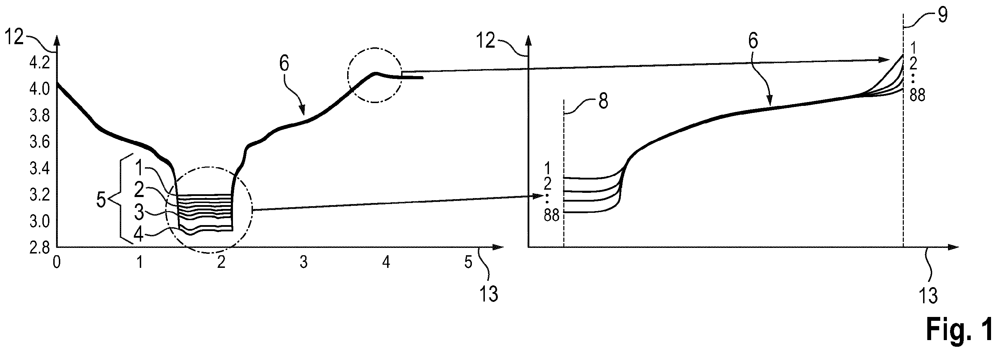

Die Fig. 1 zeigt zwei Diagramme, in denen ein Beladevorgang 6 einer Batterie 5 dargestellt ist. An den vertikalen Achsen der Diagramme ist die Spannung 12 aufgetragen. An den horizontalen Achsen der Diagramme ist die Zeit 13 aufgetragen. Die Batterie 5 umfasst eine Mehrzahl von Zellen 1, 2, 3, 4. Zu Beginn des Beladevorgangs 6 werden Entladungsspannungen 8 jeder Zelle 1, 2, 3, 4,...n, mit n = 88, gemessen. Zum Ende des Beladungsvorgangs werden Beladungsspannungen 9 jeder der Zellen 1, 2, 3, 4,....n gemessen.

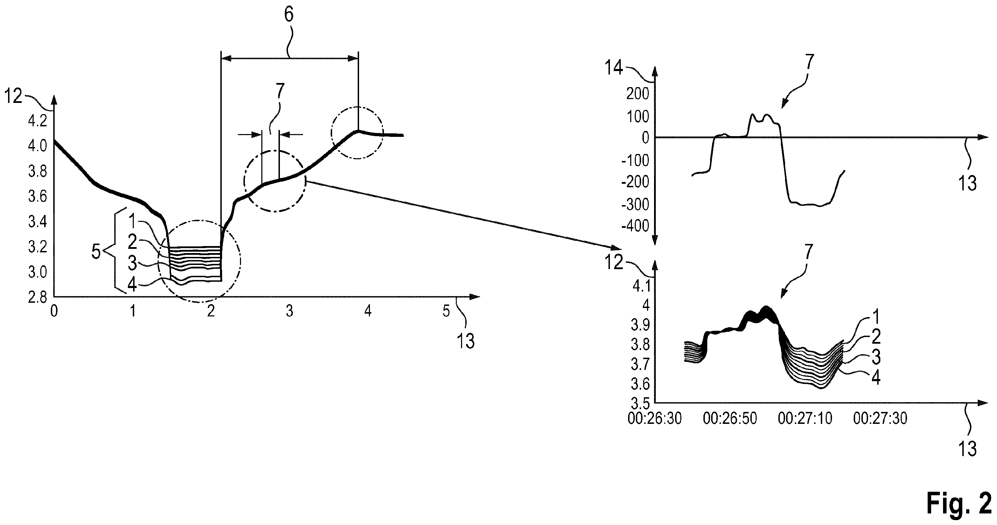

Fig. 2 zeigt drei Diagramme, in denen ein zwischenzeitlicher Entladevorgang 7 dargestellt ist. Dieser findet zeitlich während des Beladevorgangs 6 nach Fig. 1 statt. An den vertikalen Achsen der Diagramme ist die Spannung 12 bzw. an dem rechten, oberen Diagramm der Strom 14, hier Entladestrom, aufgetragen. An den horizontalen Achsen der Diagramme ist die Zeit 13 aufgetragen. Es ist erkennbar, dass während die Batterie 5 mit dem Strom 14 entladen wird, die Zellen 1, 2, 3, 4 unterschiedliche Verläufe der Spannungen 12 aufweisen. Auf die Ausführungen zu Fig. 1 wird verwiesen.

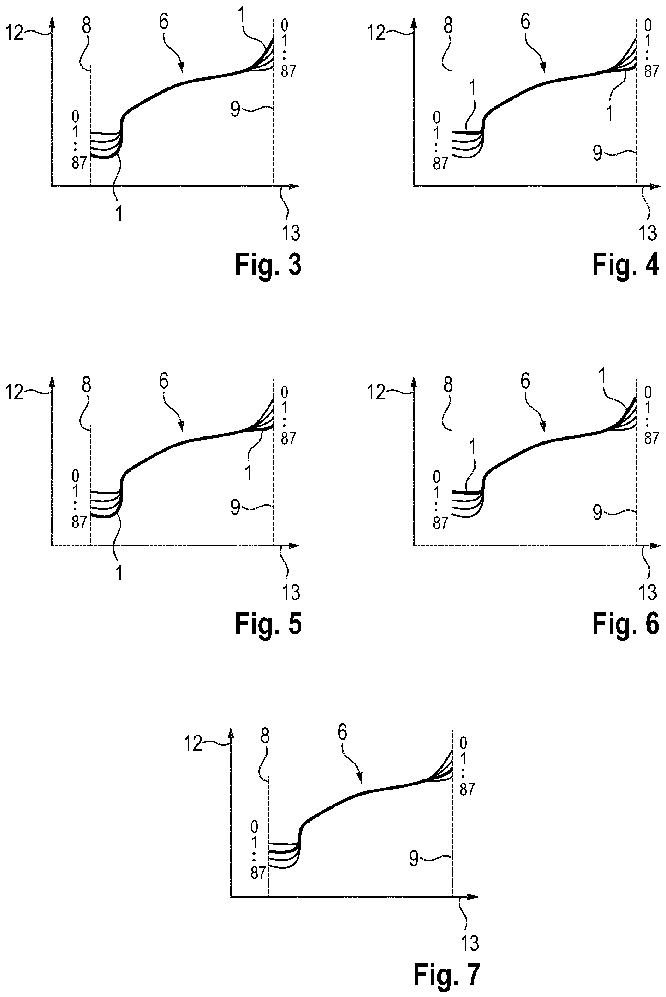

In den folgenden Figuren 3 bis 7 sind jeweils Verläufe von Spannungen 12 einzelner Zellen dargestellt, wobei die dort untersuchte Batterie 5 insgesamt 88 Zellen aufweist, hier von Zelle 0 bis Zelle 87. Der jeweils im Folgenden beschriebene Verlauf einer Spannung wird immer für eine Zelle exemplarisch erläutert, die hier als erste Zelle 1 bezeichnet wird.

Fig. 3 zeigt ein Diagramm, in dem eine Zelle 1 mit geringer Kapazität dargestellt ist. Fig. 4 zeigt ein Diagramm, in dem eine Zelle 1 mit großer Kapazität dargestellt ist. Die Fig. 3 und 4 werden im Folgenden gemeinsam beschrieben.

An den vertikalen Achsen der Diagramme ist die Spannung 12 aufgetragen. An den horizontalen Achsen der Diagramme ist die Zeit 13 aufgetragen. Die in Fig. 3 erkennbare große Differenz zwischen der Entladespannung 8 und der Beladespannung 9 der ersten Zelle 1 entspricht einer geringen Kapazität der Zelle 1, da eine geringe Menge an elektrischem Strom 14 einen großen Unterschied der Spannung 12 der Zelle 1 verursacht. Umgekehrt entspricht eine geringe Differenz einer hohen Kapazität der Zelle 1. Dieser Zustand ist in Fig. 4 dargestellt.

Fig. 5 zeigt ein Diagramm, in dem eine Zelle 1 mit negativem Gleichgewicht dargestellt ist. Fig. 6 zeigt ein Diagramm, in dem eine Zelle 1 mit positivem Gleichgewicht dargestellt ist. Fig. 7 zeigt ein Diagramm, in dem eine Zelle 1 mit ausgeglichenem Gleichgewicht dargestellt ist. Die Fig. 5 bis 7 werden im Folgenden gemeinsam beschrieben.

An den vertikalen Achsen der Diagramme ist die Spannung 12 aufgetragen. An den horizontalen Achsen der Diagramme ist die Zeit 13 aufgetragen.

Ein negatives Gleichgewicht, dargestellt in Fig. 5, bedeutet, dass eine im Vergleich mit den anderen Zellen 2, 3, 4 am tiefsten entladene erste Zelle 1, d. h. es liegt eine geringste Entladespannung 8 aller Zellen 1, 2, 3, 4 vor, in einem Beladevorgang 6 am geringsten beladen wird, d. h. es liegt eine geringste Beladespannung 9 aller Zellen 1, 2, 3, 4 vor.

Ein positives Gleichgewicht, dargestellt in Fig. 6, bedeutet, dass eine im Vergleich mit den anderen Zellen 2, 3, 4 am wenigstens entladene erste Zelle 1, d. h. es liegt eine höchste Entladespannung 8 aller Zellen 1, 2, 3, 4 vor, in einem Beladevorgang 6 am stärksten beladen wird, d. h. es liegt eine höchste Beladespannung 9 aller Zellen 1, 2, 3, 4 vor.

Ein ausgeglichenes Gleichgewicht, dargestellt in Fig. 7, bedeutet, dass eine im Vergleich mit den anderen Zellen 1, 2, 3, 4 hier drittgeringste entladene erste Zelle 1, d. h. es liegt eine drittgeringste Entladespannung 8 aller Zellen 1, 2, 3, 4 vor, in einem Beladevorgang 6 am drittstärksten beladen wird, d. h. es liegt eine dritthöchste Beladespannung 9 aller Zellen 1, 2, 3, 4 vor.

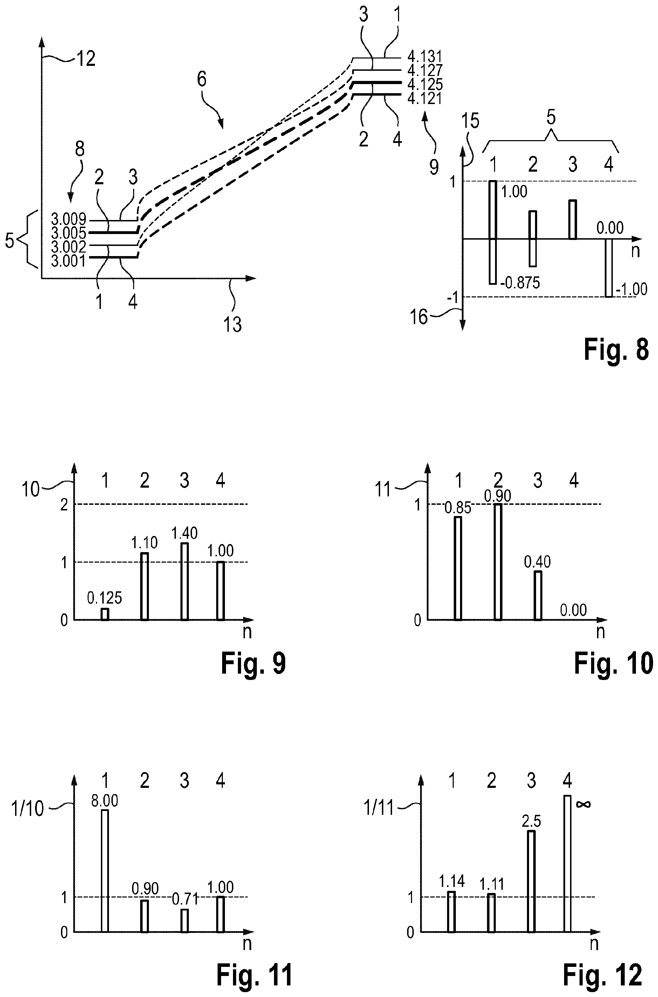

Fig. 8 zeigt zwei Diagramme, in denen ein Beladevorgang 6 einer Mehrzahl von Zellen 1, 2, 3, 4 und deren normierte Spannungen 15, 16 dargestellt sind. Bei dem linken Diagramm ist an der vertikalen Achse die Spannung 12 aufgetragen. An der horizontalen Achse ist die Zeit 13 aufgetragen. Die Batterie 5 umfasst eine Mehrzahl von Zellen 1, 2, 3, 4. Zu Beginn des Beladevorgangs 6 werden Entladungsspannungen 8 jeder Zelle 1, 2, 3, 4 gemessen. Die erste Zelle 1 weist z. B. eine Entladungsspannung 8 von 3,002 Volt auf. Zum Ende des Beladungsvorgangs 6 werden Beladungsspannungen 9 jeder der Zellen 1, 2, 3, 4 gemessen. Hier weist die erste Zelle 1 z. B. eine Beladespannung 9 von 4,131 auf.

Bei dem rechten Diagramm ist an der vertikalen Achse oberhalb der horizontalen Achse der Wert der normierten Beladespannung 15 $x_i$ und unterhalb der horizontalen Achse der Wert der normierte Entladespannung $y_i$ 16 aufgetragen. An der horizontalen Achse sind die Zellen 1, 2, 3, 4, also n, aufgetragen.

Gemäß $x_i = \frac{U_{xi} - U_{xmin}}{U_{xmax} - U_{xmin}}$ beträgt die normierte Beladungsspannung 15 der ersten Zelle 1 hier 1,0; wobei die Beladespannung 9 der betrachteten ersten Zelle 1 den Wert 4,131 aufweist, die maximale Beladespannung 9 aller betrachteten Zellen 1, 2, 3, 4 den Wert 4,131 aufweist und die minimale Beladespannung 9 aller betrachteten Zellen 1, 2, 3, 4 den Wert 4,121 aufweist.

Gemäß $y_i = \frac{U_{yi} - U_{ymin}}{U_{ymax} - U_{ymin}} - 1$ . beträgt die normierte Entladungsspannung 16 der ersten Zelle 1 hier -0,875; wobei die Entladespannung 8 der betrachteten ersten Zelle 1 den Wert 3,002 aufweist, die maximale Entladespannung 8 aller betrachteten Zellen 1, 2, 3, 4 den Wert 3,009 aufweist und die minimale Entladespannung 8 aller betrachteten Zellen 1, 2, 3, 4 den Wert 3,001 aufweist.

Fig. 9 zeigt ein Diagramm, in dem die Kapazitätsparameter 10 der Mehrzahl der Zellen 1, 2, 3 4 nach Fig. 8 dargestellt sind. An der vertikalen Achse ist der Kapazitätsparameter 10 aufgetragen. An der horizontalen Achse sind die Zellen 1, 2, 3, 4, also n, aufgetragen.

Für den Kapazitätsparameter $C_i$ 10 einer Zelle i gilt: $C_i = 2 - (x_i - y_i)$. Für die erste Zelle 1 beträgt also der Kapazitätsparameter 10 hier 0,125.

Fig. 10 zeigt ein Diagramm, in dem die Gleichgewichtsparameter 11 der Mehrzahl der Zellen 1, 2, 3, 4 nach Fig. 8 dargestellt sind. An der vertikalen Achse ist der Gleichgewichtsparameter 11 aufgetragen. An der horizontalen Achse sind die Zellen 1, 2, 3, 4, also n, aufgetragen.

Für den Gleichgewichtsparameter $B_i$ 11 einer Zelle i gilt: $B_i = 1 - |x_i + y_i|$. Für die erste Zelle 1 beträgt also der Gleichgewichtsparameter 11 hier 0,85.

Fig. 11 zeigt ein Diagramm, in dem die Kehrwerte der Kapazitätsparameter 10 nach Fig. 9 dargestellt sind. An der vertikalen Achse ist der Kehrwert des Kapazitätsparameters 10 aufgetragen. An der horizontalen Achse sind die Zellen 1, 2, 3, 4, also n, aufgetragen. Für die erste Zelle 1 beträgt also der Kehrwert des Kapazitätsparameters 10 hier 8,0.

Fig. 12 zeigt ein Diagramm, in dem die Kehrwerte der Gleichgewichtsparameter 11 nach Fig. 10 dargestellt sind. An der vertikalen Achse ist der Kehrwert des Gleichgewichtsparameters 11 aufgetragen. An der horizontalen Achse sind die Zellen 1, 2, 3, 4, also n, aufgetragen. Für die erste Zelle 1 beträgt also der Kehrwert des Gleichgewichtsparameters 11 hier 1,14.

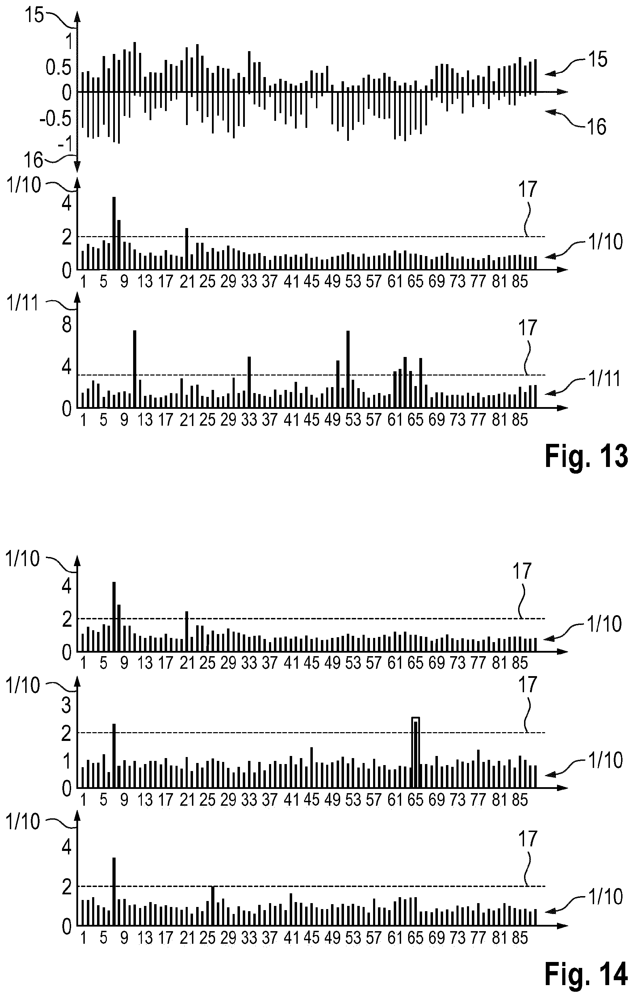

Fig. 13 zeigt drei Diagramme, in denen die normierten Spannungen 15, 16, die Kehrwerte der Kapazitätsparameter 10 und die Kehrwerte der Gleichgewichtsparameter 11 für jeweils alle Zellen 1, 2, 3, 4, ...n, mit n = 88, für einen Ladevorgang 6 dargestellt sind. In dem obersten Diagramm sind an der vertikalen Achse oberhalb der horizontalen Achse die Werte der normierten Beladespannung 15 $x_i$ und unterhalb der horizontalen Achse die Werte der normierte Entladespannung $y_i$ 16 aufgetragen.

In dem mittleren Diagramm sind an der vertikalen Achse die Kehrwerte des Kapazitätsparameters 10 aufgetragen.

Die Eingriffsgrenze 17 für den Kehrwert des Kapazitätsparameters 10 ist als 2,0 definiert.

In dem unteren Diagramm sind an der vertikalen Achse die Kehrwerte des Gleichgewichtsparameters 11 aufgetragen.

Die Eingriffsgrenze 17 für den Kehrwert des Gleichgewichtsparameters 11 ist als 3,0 definiert.

Die, die für den jeweiligen Parameter definierte Eingriffsgrenze 17 überschreitenden Zellen (hier siebte und achte, sowie 21 Zelle im mittleren Diagramm sowie die elfte, 33ste, 50ste, 52ste, 61ste bis 64ste und 66ste Zelle im unteren Diagramm), können identifiziert werden. Sollten diese Zellen auch bei weiteren Verläufen des Verfahrens entsprechende Auffälligkeiten aufweisen oder sollte eine weitere Verschlechterung auftreten, kann ggf. ein gezielter Austausch dieser Zellen erfolgen. Gemäß dem Verlauf der Veränderung der erfassten Zustandsparameter kann ein Servicetermin festgelegt werden, so dass ein Versagen der Zelle im Betrieb vermieden wird, ein zu früher Austausch der Zelle aber auch verhindert werden kann.

Fig. 14 zeigt drei Diagramme, in denen die Kehrwerte der Kapazitätsparameter 10 aller Zellen 1, 2, 3, 4, ...n, mit n = 88, für drei verschiedene Ladevorgänge 6 dargestellt sind, siehe Datumsangabe oben rechts in jedem Diagramm, also 7. September, 10. September und 11. September eines gleichen Jahres.

In den Diagrammen sind an der vertikalen Achse die Kehrwerte des Kapazitätsparameters 10 aufgetragen. An der horizontalen Achse sind die Zellen 1, 2, 3, 4, ...n, mit n = 88, aufgetragen.

Hier wurden im obersten Diagramm die siebte, achte und 21ste Zelle als ggf. schadhaft identifiziert, in dem mittleren Diagramm die siebte und die 65 Zelle, in dem unteren Diagramm die siebte und die 26ste Zelle.

Es ist erkennbar, dass über die wiederholten Messungen auch Plausibilisierungen vorgenommen werden können. Hier ist erkennbar, dass wohl nur die siebte Zelle tatsächlich schadhaft ist.

**Bezugszeichenliste**

1    erste Zelle
2    zweite Zelle
3    dritte Zelle
4    vierte Zelle
5    Batterie
6    Beladevorgang
7    Entladevorgang
8    Entladespannung
9    Beladespannung
10   Kapazitätsparameter
11   Gleichgewichtsparameter
12   Spannung
13   Zeit
14   Strom
15   normierte Beladespannung $\mathbf{x}_i$
16   normierte Entladespannung $\mathbf{y}_i$
17   Eingriffsgrenze

**Patentansprüche**

1. Verfahren zur Bestimmung eines jeweiligen Zustands einer Mehrzahl von Zellen (1, 2, 3, 4) einer Batterie (5); zumindest umfassend die folgenden Schritte:

   a) Durchführen eines Ladevorgangs, nämlich eines Beladevorgangs (6) oder eines Entladevorgangs (7) der Zellen (1, 2, 3, 4);
   b) Ermittlung einer Entladespannung (8) jeder der Zellen (1, 2, 3, 4) und einer Beladespannung (9) jeder der Zellen (1, 2, 3, 4), wobei die Entladespannung die geringste Spannung und die Beladespannung die höchste Spannung des Ladevorgangs ist;
   c) Bestimmen mindestens eines Zustandsparameters (10, 11) für jede Zelle (1, 2, 3, 4), wobei der Zustandsparameter aus der Entladespannung (8) und der Beladespannung (9) abgeleitet wird, wobei für den Zustandsparameter eine Entladespannung (8) und eine Beladespannung (9) zumindest einer anderen Zelle (4, 3, 2, 1) berücksichtigt wird;

   **dadurch gekennzeichnet, dass** der eine Zustandsparameter zumindest ein Kapazitätsparameter (10) oder ein Gleichgewichtsparameter (11) ist; wobei der Kapazitätsparameter (10) ein Verhältnis der Entladespannung (8) und der Beladespannung (9) einer Zelle (1, 2, 3, 4) unter Berücksichtigung des Verhältnisses anderer Zellen (4, 3, 2, 1) beschreibt; wobei der Gleichgewichtsparameter (11) ein Niveau der Entladespannung (8) und ein Niveau der Ladespannung (9) einer Zelle (1, 2, 3, 4) im Vergleich zu den jeweiligen Niveaus der Spannungen (8, 9) anderer Zellen (1, 2, 3, 4) beschreibt.

2. Verfahren nach Patentanspruch 1, wobei der mindestens eine Zustandsparameter für eine Mehrzahl zumindest von Beladevorgängen (6) oder Entladevorgängen (7) ermittelt wird, wobei eine Entwicklung der so ermittelten Zustandsparameter berücksichtigt wird.

3. Verfahren nach einem der vorhergehenden Patentansprüche, wobei zum Bestimmen der Zustandsparameter die ermittelte Entladespannung (8) und Beladespannung (9) jeder Zelle (1, 2, 3, 4) normiert wird; wobei für die normierte Beladespannung $\mathbf{x}_i$ (15) einer Zelle i gilt: $x_i = \dfrac{U_{xi} - U_{xmin}}{U_{xmax} - U_{xmin}}$ ; wobei für die normierte Entladespannung $y_i$ (16) einer Zelle i gilt:

   $$y_i = \frac{U_{yi} - U_{ymin}}{U_{ymax} - U_{ymin}} - 1 \quad ; \quad \text{wobei}$$

   $U_{xi}$: die Beladespannung (9) der betrachteten Zelle i,
   $U_{xmin}$: die maximale Beladespannung (9) aller betrachteten Zellen i = 1 bis n,
   $U_{xmin}$: die minimale Beladespannung (9) aller betrachteten Zellen i = 1 bis n,
   $U_{yi}$: die Entladespannung (8) der betrachteten Zelle i,
   $U_{ymin}$: die maximale Entladespannung (8) aller betrachteten Zellen i = 1 bis n,
   $U_{xmin}$: die minimale Entladespannung (8) aller betrachteten Zellen i = 1 bis n ist.

4. Verfahren nach Patentanspruch 3, wobei der mindestens eine Zustandsparameter ein Kapazitätsparameter (10) $C_i$ einer Zelle i ist, wobei gilt: $C_i = 2 - (x_i - y_i)$.

5. Verfahren nach einem der vorhergehenden Patentansprüche 3 und 4, wobei der mindestens eine Zustandsparameter ein Gleichgewichtsparameter (11) $B_i$ einer Zelle i ist, wobei gilt: $B_i = 1 - |x_i + y_i|$.

6. Verfahren nach einem der vorhergehenden Patentansprüche 4 und 5, wobei zur Bestimmung des Zustands einer Zelle (1, 2, 3, 4) ein Kehrwert des Zustandsparameters betrachtet wird.

7. Verfahren nach Patentanspruch 6, wobei für jeden Zustandsparameter eine Eingriffsgrenze (17) definiert ist, bei deren Überschreitung auf einen Reparatur-Status der betreffenden Zelle (1, 2, 3, 4) entschieden wird.

8. Verfahren nach Patentanspruch 7, wobei die Eingriffsgrenze (17) in Abhängigkeit von den für die Mehrzahl der Zellen (1, 2, 3, 4) bestimmten Zustandsparameter bestimmt wird.

9. Verfahren nach Patentanspruch 8, wobei die Eingriffsgrenze (17) für den jeweils letzten Beladevorgang (6) oder Entladevorgang (7) neu bestimmt wird.

10. Steuergerät, konfiguriert zur Durchführung des Verfahrens nach einem der vorhergehenden Ansprüche 1 bis 9.


**Claims**

1. Method for determining a state of a plurality of cells (1, 2, 3, 4) of a battery (5); at least comprising the following steps:

   a) carrying out a charging process, namely a recharging process (6) or a discharging process (7) of the cells (1, 2, 3, 4);
   b) determining a discharge voltage (8) of each of the cells (1, 2, 3, 4) and a recharge voltage (9) of each of the cells (1, 2, 3, 4), the discharge voltage being the lowest voltage and the recharge voltage being the highest voltage of the charging process;
   c) determining at least one state parameter (10, 11) for each cell (1, 2, 3, 4), the state parameter being derived from the discharge voltage (8) and the recharge voltage (9), a discharge voltage (8) and a recharge voltage (9) of at least one other cell (4, 3, 2, 1) being taken into account for the state parameter;
   **characterized in that** the one state parameter is at least one capacity parameter (10) or one equilibrium parameter (11); the capacity parameter (10) describing a ratio of the discharge voltage (8) and the recharge voltage (9) of a cell (1, 2, 3, 4) taking into account the ratio of other cells (4, 3, 2, 1); the equilibrium parameter (11) describing a level of the discharge voltage (8) and a level of the charge voltage (9) of a cell (1, 2, 3, 4) in comparison to the respective levels of the voltages (8, 9) of other cells (1, 2, 3, 4).

2. Method according to claim 1, wherein the at least one state parameter is determined for a plurality of at least recharging processes (6) or discharging processes (7), wherein a development of the state parameters thus determined is taken into account.

3. Method according to either of the preceding claims, wherein, to determine the state parameters, the determined discharge voltage (8) and recharge voltage (9) of each cell (1, 2, 3, 4) are standardized; where for the standardized recharge voltage $x_i$ (15) of a cell i: $x_i = \dfrac{U_{xi} - U_{xmin}}{U_{xmax} - U_{xmin}}$ ; where for the standardized discharge voltage $y_i$ (16) of a cell i:

$$y_i = \frac{U_{yi} - U_{ymin}}{U_{ymax} - U_{ymin}} - 1 \qquad ; \qquad \text{where}$$

   $U_{xi}$: the recharge voltage (9) of the considered cell i,
   $U_{xmin}$: the maximum recharge voltage (9) of all considered cells i = 1 to n,
   $U_{xmin}$: the minimum recharge voltage (9) of all considered cells i = 1 to n,
   $U_{yi}$: the discharge voltage (8) of the considered cell i,
   $U_{ymin}$: the maximum discharge voltage (8) of all considered cells i = 1 to n,
   $U_{xmin}$: the minimum discharge voltage (8) of all considered cells i = 1 to n.

4. Method according to claim 3, wherein the at least one state parameter is a capacity parameter (10) $C_i$ of a cell i, where: $C_i = 2 - (x_i - y_i)$.

5. Method according to either of the preceding claims 3 and 4, wherein the at least one state parameter is an equilibrium parameter (11) $B_i$ of a cell i, where: $B_i = 1 - |x_i + y_i|$.

6. Method according to either of the preceding claims 4 and 5, wherein, to determine the state of a cell (1, 2, 3, 4), an inverse value of the state parameter is considered.

7. Method according to claim 6, wherein an intervention limit (17) is defined for each state parameter, beyond which limit a repair status of the cell in question (1, 2, 3, 4) is decided.

8. Method according to claim 7, wherein the intervention limit (17) is determined depending on the state parameters determined for the plurality of cells (1, 2, 3, 4).

9. Method according to claim 8, wherein the intervention limit (17) is newly determined for each last recharging process (6) or discharging process (7).

10. Control unit designed to carry out a method according to any of claims 1 to 9.

**Revendications**

1. Procédé pour la détermination d'un état respectif d'une pluralité de cellules (1, 2, 3, 4) d'une batterie (5) ; comprenant au moins les étapes suivantes :

   a) mise en œuvre d'un processus de charge, à savoir un processus de recharge (6) ou un processus de décharge (7) des cellules (1, 2, 3, 4) ;
   b) détection d'une tension de décharge (8) de chacune des cellules (1, 2, 3, 4) et d'une tension de recharge (9) de chacune des cellules (1, 2, 3, 4), dans lequel la tension de décharge est la tension la plus faible et la tension de recharge est la tension la plus élevée du processus de charge ;
   c) détermination d'au moins un paramètre d'état (10, 11) pour chaque cellule (1, 2, 3, 4), dans lequel le paramètre d'état est déduit de la tension de décharge (8) et de la tension de recharge (9), dans lequel une tension de décharge (8) et une tension de recharge (9) d'au moins une autre cellule (4, 3, 2, 1) sont prises en compte pour le paramètre d'état ;
   **caractérisé en ce que** ledit un paramètre d'état est au moins un paramètre de capacité (10) ou un paramètre d'équilibre (11) ; dans lequel le paramètre de capacité (10) décrit un rapport entre la tension de décharge (8) et la tension de recharge (9) d'une cellule (1, 2, 3, 4) en prenant en compte le rapport d'autres cellules (4, 3, 2, 1) ; dans lequel le paramètre d'équilibre (11) décrit un niveau de la tension de décharge (8) et un niveau de la tension de recharge (9) d'une cellule (1, 2, 3, 4) par rapport aux niveaux respectifs des tensions (8, 9) d'autres cellules (1, 2, 3, 4).

2. Procédé selon la revendication 1, dans lequel l'au moins un paramètre d'état est détecté pour une pluralité d'au moins des processus de recharge (6) ou des processus de décharge (7), dans lequel une évolution des paramètres d'état ainsi déterminés est prise en compte.

3. Procédé selon l'une des revendications précédentes, dans lequel, pour la détermination des paramètres d'état, la tension de décharge (8) et la tension de recharge (9) déterminées de chaque cellule (1, 2, 3, 4) sont normalisées ; dans lequel, pour la tension de recharge normalisée $x_i$ (15) d'une cellule i :

$$x_i = \frac{U_{xi} - U_{xmin}}{U_{xmax} - U_{xmin}}$$ ; dans lequel, pour la tension de décharge normalisée $y_i$ (16) d'une cellule i :

$$y_i = \frac{U_{yi} - U_{ymin}}{U_{ymax} - U_{ymin}} - 1$$ ; où

$U_{xi}$ : la tension de recharge (9) de la cellule i considérée,
$U_{xmax}$ : la tension de recharge (9) maximale de toutes les cellules i = 1 à n considérées,
$U_{xmin}$ : la tension de recharge (9) minimale de toutes les cellules i = 1 à n considérées,
$U_{yi}$ : la tension de décharge (8) de la cellule i considérée,
$U_{ymax}$ : la tension de décharge (8) maximale de toutes les cellules i = 1 à n considérées,
$U_{ymin}$ : la tension de décharge (8) minimale de toutes les cellules i = 1 à n considérées.

4. Procédé selon la revendication 3, dans lequel l'au moins un paramètre d'état est un paramètre de capacité (10) $C_i$ d'une cellule i, dans lequel : $C_i = 2 - (x_i - y_i)$.

5. Procédé selon l'une des revendications précédentes 3 et 4, dans lequel l'au moins un paramètre d'état est un paramètre d'équilibre (11) $B_i$ d'une cellule i, dans lequel : $B_i = 1 - |x_i + y_i|$.

6. Procédé selon l'une des revendications précédentes 4 et 5, dans lequel, pour la détermination de l'état d'une cellule (1, 2, 3, 4), une valeur inverse du paramètre d'état est considérée.

7. Procédé selon la revendication 6, dans lequel, pour chaque paramètre d'état, une limite d'intervention (17) est définie, au-delà de laquelle un état de réparation de la cellule (1, 2, 3, 4) concernée est décidé.

8. Procédé selon la revendication 7, dans lequel la limite d'intervention (17) est déterminée en fonction des paramètres d'état déterminés pour la pluralité de cellules (1, 2, 3, 4).

9. Procédé selon la revendication 8, dans lequel la limite d'intervention (17) est déterminée à nouveau pour chaque dernier processus de recharge (6) ou processus de décharge (7).

10. Appareil de commande configuré pour mettre en œuvre le procédé selon l'une des revendications 1 à 9.

Fig. 1

EP 4 165 422 B1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102009000337 A1
- DE 102011117249 A1
- DE 102014214314 A1
- US 2014278169 A1
- US 2016266210 A1